**Europäisches Patentamt**

**European Patent Office**

**Office européen des brevets**

(19)

(11) Veröffentlichungsnummer : **0 074 927**
**B1**

(12) **EUROPÄISCHE PATENTSCHRIFT**

(45) Veröffentlichungstag der Patentschrift :
04.05.88

(51) Int. Cl.⁴ : **H 03 K 17/94, G 02 F   1/01**

(21) Anmeldenummer : **82810374.7**

(22) Anmeldetag : **08.09.82**

(54) Schalteinrichtung mit einer Lichtleitfaser.

(30) Priorität : 11.09.81 CH 5914/81

(43) Veröffentlichungstag der Anmeldung :
23.03.83 Patentblatt 83/12

(45) Bekanntmachung des Hinweises auf die Patenterteilung : 04.05.88 Patentblatt 88/18

(84) Benannte Vertragsstaaten :
AT CH DE GB LI

(56) Entgegenhaltungen :
FR-A- 2 418 506
GB-A- 2 019 561
GB-A- 2 046 437
NL-A- 7 802 054
US-A- 3 411 010
US-A- 4 268 116
OPTICS LETTERS, Band 6, Nr. 1, Januar 1981, Seiten
16-18, Optical Society of America, New York, US; N.
CHINONE u.a.: "Elasto-optic polarization measurement in optical fiber"

(73) Patentinhaber : FELLER AG.
Bergstrasse
CH-8810 Horgen (CH)

(72) Erfinder : Falco, Lucien
Rue du Vignoble 68
CH-2087 Cornaux (CH)
Erfinder : Zetting, Alois
Strehlgasse 12
CH-8704 Herrliberg (CH)

(74) Vertreter : Haffter, Tobias Fred, Dr. Dipl.-Phys. et al
PATENTANWALTS-BUREAU ISLER AG Postfach 6940
Walchestrasse 23
CH-8023 Zürich (CH)

EP 0 074 927 B1

## Beschreibung

Die Erfindung bezieht sich auf eine Schalteinrichtung mit einer Lichtleitfaser gemäss dem Oberbegriff des Patentanspruchs 1.

In der Zeitschrift « Laser Focus », Oktober 1980, ist eine Schalteinrichtung zur Verwendung in einem Tastenfeld eines Dateneingabegerätes beschrieben, bei welcher der Durchgang inkohärenten Lichts durch eine Lichtleitfaser am Ort der ihr zugeordneten Taste durch Tastenbetätigung unterbrochen wird. Hierzu weist die Lichtleitfaser am Ort der Taste einen bogenförmigen Abschnitt auf, der im Bereich seines Scheitels und auf seiner Aussenseite vom Mantel der Lichtleitfaser befreit ist. In einem geringen Abstand oberhalb dieses Scheitelbereichs ist eine kleine durchbiegbare Platte angeordnet, deren Brechungsindex grösser als derjenige des Kerns der Lichtleitfaser ist. Durch Niederdrücken dieser Platte auf den umhüllungsfreien Abschnitt der Lichtleitfaser wird mindestens ein Teil des durch die Lichtleitfaser laufenden Lichts nach aussen abgelenkt bzw. von der Platte absorbiert, so dass der am Ende der Lichtleitfaser angeordnete Lichtdetektor eine Verminderung der Lichtintensität feststellt und aufgrund dieser Erscheinung einen Schaltvorgang bewirken kann.

Für andere Anwendungen als bei einem Tastenfeld weist die bekannte Schalteinrichtung jedoch verschiedene Nachteile auf. Insbesondere dann, wenn die durch die Lichtleitfaser gebildete Steuerleitung eine beträchtliche Länge hat und wenn ein oder mehrere Betätigungsglieder zur Beeinflussung der Intensität des durch die Lichtleitfaser übertragenen Lichts an beliebigen, vor dem Verlegen der Lichtleitfaser nicht festgelegten Stellen längs der Lichtleitfaser angeordnet werden sollen, ist die bekannte Schalteinrichtung wenig geeignet. Da das Schalt- bzw. Detektionskriterium ein reines Intensitätskriterium ist, können andere Intensitätsverluste die Diskriminierempfindlichkeit des Lichtdetektors nachteilig beeinflussen. Ferner muss der zu beeinflussende Abschnitt der Lichtleitfaser haarnadel- oder hufeisenförmig gebogen sein, was es erschwert oder gar verunmöglicht, Betätigungsglieder an beliebiger Stelle einer langgestreckten Lichtleitfaser ohne Verwendung kostspieliger und optisch problematischer Verbindungselemente, z. B. Steckverbindungen, anzuordnen.

Aus der US-Patentschrift 4 297 684 und der GB-Patentanmeldung 2 057 120 A sind Alarm- und Messeinrichtungen bekannt, bei welchen in eine als Detektorleitung dienende, deformierbare Multimode-Lichtleitfaser kohärentes Licht eines Lasers eingespeist wird und am Lichtleitfaserende durch den Lichtdetektor das zufolge von Uebertragungszeitdifferenzen auftretende Muster von Lichtflecken überwacht wird. Dieses Lichtfleckmuster verändert sich, wenn die Lichtleitfaser (z. B. in einer Einbruchsicherungsanlage) verschoben oder (z. B. in einer Unterwasser-Schalldetektionsanlage) akustischen Schwingungen ausgesetzt wird. Die Lageveränderung des Lichtfleckmusters wird hierbei durch den Lichtdetektor festgestellt, um einen Alarm auszulösen oder eine Messgrösse zu erzeugen.

Aus der britischen Patentanmeldung A-2 019 561 ist ferner eine Schalteinrichtung mit einer Lichtleitfaser bekannt, an deren einem Ende eine Quelle mindestens angenähert kohärenten Lichts und an deren anderem Ende ein mindestens einen photoelektrischen Lichtfühler zur Feststellung und Unterscheidung von durch Einwirkungen auf die Lichtleitfaser hervorgerufenen Aenderungen der optischen Phaseneigenschaften der sich in der Lichtleitfaser fortpflanzenden und am zweitgenannten Ende austretenden Lichts angeordnet sind. Hierbei ist mindestens ein Lichtleitfaserabschnitt mit einer elastischen Betätigungsvorrichtung zur Ausübung eines gezielten transversalen Drucks auf die Lichtleitfaser versehen. Zudem enthält der Lichtdetektor ein an den photoelektrischen Lichtfühler angeschlossenes Bandpassfilter.

Es ist auch aus der französischen Patentanmeldung A-2 418 506 eine Einrichtung mit einer Lichtleitfaser zur Feststellung der Anwesenheit eines Objektes längs einer Leitung bekannt, welche eine Vorrichtung enthält, die eine gezielte und beschränkte transversale Verschiebung der Lichtleitfaser bewirkt.

Schliesslich ist aus der britischen Patentanmeldung A-4 046 437 bzw. der deutschen Patentanmeldung A-30 11 052 eine Einbruchssicherungseinrichtung mit einer als optisches Multimode-Faserkabel als Detektorleitung, mit einer an das eine Kabelende kohärentes Licht einspeisenden Lichtquelle und mit einem im Austrittskegel am anderen Kabelende angeordneten Lichtdetektor bekannt. Der Lichtdetektor weist einen Empfangsschirm auf, auf dem aus dem Kabelende austretende Lichtflecken in einem Sprenkelmuster abgebildet werden. Die Detektorleitung wirkt als Erschütterungsfühler, indem auf das Faserkabel einwirkende Erschütterungen, insbesondere Lageänderungen, eine Aenderung der optischen Uebertragungseigenschaften des Faserkabels und damit eine Lageänderung der Lichtflecken zur Folge haben, die zur Ueberwachung ausgenutzt werden.

Nachteilig ist bei den bekannten Alarm- und Messeinrichtungen, dass Temperaturänderungen und andere als die zu erfassenden Erschütterungs- und Schwingungseinwirkungen auf die Lichtleitfaser Störsignale erzeugen, welche die Feststellung einer gezielten Einwirkung auf die Lichtleitfaser erschweren oder gar verunmöglichen.

Der im Patentanspruch 1 beanspruchte Erfindungsgegenstand schafft eine Schalteinrichtung der eingangs genannten Art, welche die Erfassung einer gezielten, wiederholbaren Verschiebeeinwirkung auf die Lichtleitfaser an einer beliebigen Stelle längs der Lichtleitfaser unter Eliminierung von Störeinflüssen und die Auslösung eines entsprechenden Schaltvorganges ermöglicht. Somit können Betätigungsvorrichtungen der beanspruchten Art in einfacher Weise an beliebigen Stellen oder kontinuierlich längs einer Lichtleitfaser angeordnet bzw. ausgebildet werden, wobei die Lichtleitfaser im wesentlichen beliebig lang und beliebig verlaufend sein kann. Die erfindungsgemässe Schalteinrichtung eignet sich somit insbesondere zu einer universellen, kostengünstigen Herstellung stromfreier, explosions- und korrosionssicherer Schaltanlagen in Gebäuden anstelle der üblichen elektrischen Verdrahtungen und Schalter, deren Verlauf bzw. Plazierung bekanntlich im voraus festgelegt werden muss bzw. nachträglich nur unter beträchtlichem Aufwand geändert oder ergänzt werden kann.

Ausführungsbeispiele des Erfindungsgegenstandes werden nachstehend anhand der Zeichnungen erläutert.

Es zeigen :

Fig. 1 eine schematische Darstellung einer analogen Schalteinrichtung mit einer Multimode-Lichtleitfaser gemäss der Erfindung,

Fig. 2 und Fig. 3 schematische Darstellungen einer digitalen Schalteinrichtung mit einer Multimode-Lichtleitfaser gemäss der Erfindung,

Fig. 4a bis Fig. 4d Darstellungen verschiedener Betätigungsvorrichtungen für die Schalteinrichtungen der Fig. 1 und 2,

Fig. 5a bis Fig. 5c und Fig. 6 Darstellungen einer ein Kabel bildenden Kombination einer Lichtleitfaser und einer Betätigungsvorrichtung,

Fig. 7a und Fig. 7b schematische Darstellungen einer grossflächigen Schalteinrichtung mit einem Kabel der Fig. 5a bis 5c,

Fig. 8 einen Schnitt durch ein eine Lichtleitfaser enthaltendes Flachkabel,

Fig. 9 eine schematische Darstellung einer Schalteinrichtung mit einer Lichtleitfaser und zusätzlichen Mitteln zu einer Informationsübertragung, und

Fig. 10 eine schematische perspektivische Ansicht eines Wandelements der Schalteinrichtung der Fig. 9.

An sich wäre es denkbar, in der vorliegenden Schalteinrichtung mit einer Multimode-Lichtleitfaser einen durch Druckeinwirkung auf eine beliebige Stelle der Lichtleitfaser am lichtdetektorseitigen Ende der Lichtleitfaser einen Doppelbrechungseffekt festzustellen und auszuwerten, wie dies mit einer Monomode-Lichtleitfaser ohne weiteres gangbar und vorteilhaft ist. Bei einer Multimode-Lichtleitfaser ist jedoch kein globaler Doppelbrechungseffekt feststellbar, da das Lichtbündel, gesamthaft betrachtet, unpolarisiert ist. Bei einer Multimode-Lichtleitfaser liegt bekanntlich entweder ein Kern von etwa 50 bis 600 $\mu$m Durchmesser mit einem Mantel mit etwas niedrigerem Brechungsindex und einer Dicke von wenigen $\mu$m (Stufenprofilfaser) oder ein Kern von etwa 50 bis 100 $\mu$m Durchmesser vor, der stetig in einen Mantel mit niedrigerem Brechungsindex und mit einem äusseren Durchmesser von etwa 200 $\mu$m übergeht. Der Mantel ist zudem von einer Schutzumhüllung umgeben. Bei einer solchen Lichtleitfaser ist mit ausreichend kohärentem, eingespeistem Licht das Licht über den Querschnitt des detektorseitigen Lichtleitfaserendes nicht gleichmässig, sondern aufgrund der lokalen Phasenverschiebungen der Lichtwellen in der Form von Lichtflecken (speckles, speckling) inhomogen und zufällig verteilt. An diesen Lichtflecken kann an sich eine durch Druckausübung auf die Lichtleitfaser hervorgerufene Doppelbrechung gemessen werden. In der Praxis ist ein solches Messverfahren wegen der geringen Abmessungen der Lichtflecken und ihrer durch äussere Einflüsse auf die Lichtleitfaser bedingten veränderlichen Verteilung über den Querschnitt der Lichtleitfaser mit erheblichen Nachteilen behaftet.

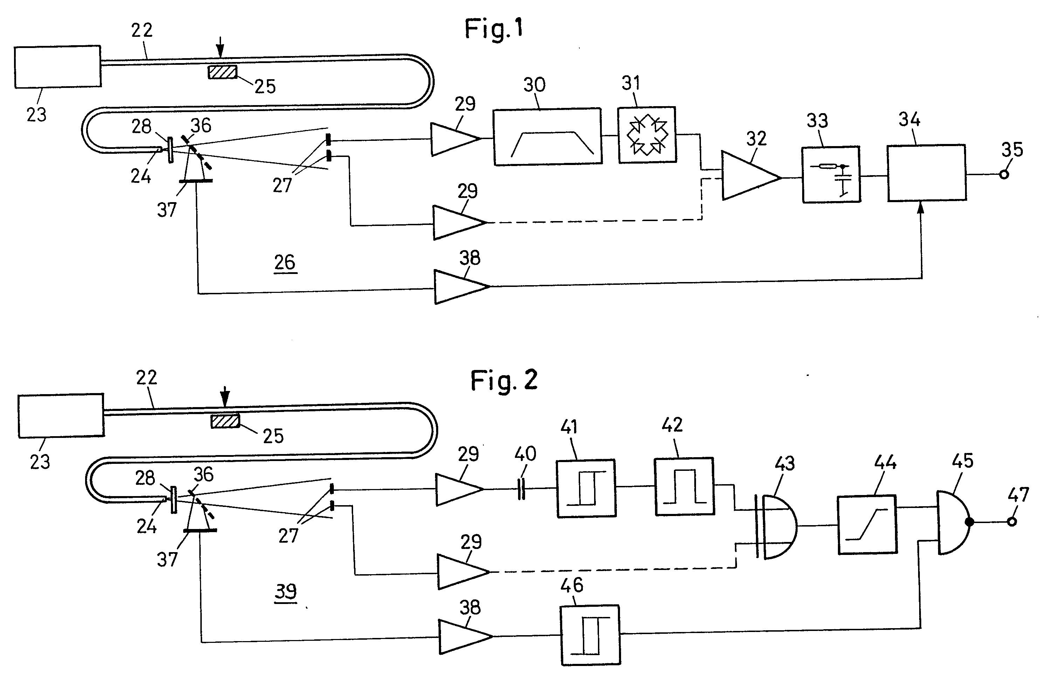

Dagegen ist es möglich, durch eine mechanische Einwirkung auf die Lichtleitfaser die Fortpflanzungseigenschaften der Lichtstrahlen (Ausbreitungsmoden) zu verändern, was in bekannter Weise eine Aenderung der Lichtverteilung am Lichtleitfaserende zur Folge hat. Eine örtliche Messung der Lichtverteilung an einem oder mehreren Punkten des Lichtleitfaserendes erlaubt dann die Feststellung der erfolgten Einwirkung auf die Lichtleitfaser. Anhand der Fig. 1 wird im folgenden ein Ausführungsbeispiel einer Schalteinrichtung beschrieben, welche vom genannten Messprinzip Gebrauch macht.

Gemäss Fig. 1 ist in eine Multimode-Lichtleitfaser 22 beliebiger Länge, die auch gekrümmt verlegt sein kann, mit Hilfe von nicht dargestellten optischen Mitteln das kohärente Licht eines Lasers 23 eingespeist, um am offenen Ende 24 der Lichtleitfaser 22 eine Lichtverteilung in der Form von Lichtflecken (speckling) zu erzielen. Die mit einer Schutzumhüllung versehene Lichtleitfaser 22 ist an einer oder mehreren Stellen mit einer elastischen Unterlage 25 versehen, die eine seitliche Deformation der Lichtleitfaser bei der Ausübung eines leichten, durch einen Pfeil angedeuteten Druckes auf die Lichtleitfaser 22, z. B. mittels eines leichten Fingerdruckes, erlaubt, wobei die seitliche Deformation weniger als 1 mm betragen kann. Zur Erfassung der genannten fleckenförmigen Lichtverteilung ist am Ende 24 der Lichtleitfaser 22 ein gesamthaft mit 26 bezeichneter Lichtdetektor angeordnet.

Der Lichtdetektor 26 umfasst einen oder mehrere photoelektrische Lichtfühler 27, von welchen jeder einen Raumwinkel erfasst, der kleiner als die Abmessung eines zugeordneten Lichtflecks ist. Diese Abmessung wird durch den Kerndurchmesser der Lichtleitfaser und durch die Wellenlänge des verwendeten Lichts bestimmt. Für eine Standard-Lichtleitfaser mit einem Kerndurchmesser von 50 $\mu$m und für Rotlicht oder Licht des nahen Infrarotbereichs entspricht die Lichtfleckabmessung einem Oeffnungswinkel von ungefähr 30 mrad oder 2°. Die Verwendung von zu grossen Lichtfühlern vermindert die Modulation des aufgenommenen Signals. Die Anzahl der anzuordnenden Lichtfühler hängt davon ab, welche Sicherheit für die Auslösung des Lichtdetektors 26 bezüglich der durch die mechanische Einwirkung auf die Lichtleitfaser hervorgerufenen geometrischen Deformation der Lichtleitfaser gefordert wird ; diese Fühleranzahl ist demnach an die Festigkeit der deformierbaren Unterlage 25 gebunden. Bei typischen Anwendungen sind ein bis vier Lichtfühler 27 genügend. Zwischen das Ende 24 der Lichtleitfaser 22 und die Lichtfühler 27 kann gemäss Fig. 1 ein Polarisator 28 angeordnet werden, welcher die relative Modulation der aufgenommenen Signale im Prinzip um einen Faktor $\sqrt{2}$ erhöht.

Das von dem oder den Lichtfühlern 27 abgegebene Nutzsignal wird von den Intensitätsänderungen des auf die Fühler 27 fallenden Lichtes geliefert, wenn sich zufolge einer manuell oder mit anderen Mitteln vorgenommenen örtlichen Deformation der Lichtleitfaser 22 die fleckenförmige Lichtverteilung am Lichtleitfaserende 24 ändert. Um Fehlauslösungen des Lichtdetektors 26 als Folge von Störeinflüssen auf die Lichtleitfaser 22 (Temperaturänderungen der Lichtleitfaser, akustischen und mechanischen Erschütterungseinwirkungen auf die Lichtleitfaser) zu vermeiden, ist es zweckmässig, die elektrischen Signale der Lichtfühler 27 nicht direkt zur Steuerung einer Triggerschaltung zu verwenden, sondern sie zuerst über entsprechende Filterschaltungen zu führen.

Beim Ausführungsbeispiel der Fig. 1 ist das elektrische Signal jedes Lichtfühlers 27 über einen Verstärker 29 (beispielsweise einen Operationsverstärker) einem Bandpassfilter 30 zugeführt. Das Bandpassfilter 30 kann aus der Reihenschaltung eines Tiefpassfilters und eines Hochpassfilters mit festen oder einstellbaren frequenzbestimmenden Bauteilen (Kondensatoren und Widerständen) sein. Das Tiefpassfilter, dessen Grenzfrequenz typischerweise bei 10 Hz liegt, schwächt akustische und mechanische Störungen (Schwingungen). Das Hochpassfilter, dessen Grenzfrequenz typischerweise bei 1 bis 4 Hz liegt, unterdrückt Störungen thermischer Herkunft.

Eine an jedes Bandpassfilter 30 angeschlossene Gleichrichterschaltung 31 ermöglicht eine Erhöhung der Empfindlichkeit des vorliegenden Lichtdetektors. Die gleichgerichteten Signale beider Lichtfühler 27 sind hierauf einem Summenverstärker 32 zugeführt. Der Ausgang des Summenverstärkers 32 ist über ein RC-Integrationsglied 33 mit dem Eingang einer Triggerschaltung 34 verbunden. Durch das Integrationsglied 33, das eine Zeitkonstante von etwa 0,1 s hat, wird die Wirkung erzielt, dass die Triggerschaltung 34 nur anspricht, wenn die von den Lichtfühlern 27 festgestellte Lageveränderung der Lichtflecken ein elektrisches Signal ausreichender Grösse bezüglich Amplitude und Dauer erreicht hat.

Die Auslösung der Triggerschaltung 34 zur Abgabe eines entsprechenden Schalt- oder Steuersignals an ihrem Ausgang 35 soll nur erfolgen, wenn das Eingangssignal eine bestimmte Ansprechschwelle erreicht, welche in Abhängigkeit von der vorgesehenen Verwendung der vorliegenden Schalteinrichtung festzulegen ist. Diese Ansprechschwelle kann beispielsweise in Abhängigkeit vom Mittelwert der Summe der von den Lichtfühlern 27 festgestellten Intensitäten festgelegt werden. Hierzu ist im Strahlengang des aus dem Lichtleitfaserende 24 austretenden Lichts als Strahlenteiler ein halbdurchlässiger Spiegel 36 angeordnet. Das abgelenkte Licht wird von einem weiteren Lichtfühler 37 total erfasst. Ueber einen Verstärker 38 wird das Messignal des Lichtfühlers 37 der Triggerschaltung 34 zur Festlegung ihrer Ansprechschwelle zugeführt, derart, dass die Triggerschaltung 34 dann anspricht, wenn die ihrem Eingangssignal entsprechende Intensität grösser als ein kleiner Bruchteil der totalen Intensität ist. Der Bruchteil, elektrisch einstellbar beispielsweise im Verstärker 38, wird hierbei unter Berücksichtigung der jeweiligen Sicherheitserfordernisse und der Intensitäts- und Modulationspegel gewählt. Die Ansprechschwelle der Triggerschaltung 34 kann aber auch mittels einer über ein Potentiometer zugeführten Gleichspannung fest eingestellt werden.

In Fig. 2 ist eine der Schalteinrichtung der Fig. 1 entsprechende Schalteinrichtung beschrieben, die jedoch einen digital arbeitenden Lichtdetektor 39 enthält. Hierin sind die optischen und elektrooptischen Teile die gleichen wie in Fig. 1 und somit auch gleich bezeichnet, nämlich die Lichtleitfaser 22, der Laser 23, die Unterlage 25, die photoelektrischen Lichtfühler 27, der Polarisator 28, der weitere photoelektrische Lichtfühler 37, der Licht über den halbdurchlässigen Spiegel 36 erhält, sowie darüber hinaus die Verstärker 29 und 38, die in die Ausgangsleitungen der Lichtfühler 27 bzw. des Lichtfühlers 37 geschaltet sind.

An den Ausgang jedes Verstärkers 29 ist im Lichtdetektor 39 über einen die untere Ansprechfrequenz grob festlegenden Kondensator 40 ein Schwellwertdetektor 41 mit Hysterese angeschlossen, z. B. ein Schmitt-Trigger, dessen Ausgang mit einem digitalen Bandpassfilter 42 verbunden ist. An die Ausgänge aller Bandpassfilter sind separate Eingänge eines Exklusiv-ODER-Gatters oder Binär-Komparators 43 angeschlossen, dessen Ausgang über ein Integrationsglied 44 mit dem einen Eingang eines NAND-Gatters 45 in Verbindung steht. Der andere Eingang des NAND-Gatters 45 ist über einen weiteren Schwellwertdetektor 46 an den Ausgang des Verstärkers 38 des weiteren Lichtfühlers 37 angeschlossen. Das NAND-Gatter 45 hat einen Ausgang 47 zum Anschluss eines Schaltelements für einen Verbraucher oder dgl.

Der Lichtdetektor 39 der Fig. 2 arbeitet entsprechend dem bereits beschriebenen Lichtdetektor 26 der Fig. 1, jedoch erfolgt durch ihn eine digitale statt einer analogen Auswertung der von den Lichtfühlern 27, 37 abgegebenen elektrischen Signale. Der Vorteil der digitalen Auswertung durch den Lichtdetektor 39 liegt vor allem in einer gegenüber der analogen Auswertung besseren, einfacheren und kostengünstigeren Ausbildungsmöglichkeit der Schaltungsteile 41 bis 45 als integrierte Schaltungen sowie in der idealen Filtercharakteristik des digitalen Bandpassfilters 42.

Dieses Bandpassfilter eignet sich zufolge seiner Digitalbauweise insbesondere zur Ausblendung mechanischer und thermischer Störgrössen, die in der Lichtleitfaser 22 entstehen können und von den Lichtfühlern 27 in entsprechende elektrische Störsignale umgewandelt werden, was beispielsweise beim Einsatz der vorliegenden Lichtleiter-Schalteinrichtung in Fahrzeugen von grosser Bedeutung sein kann. Das Signal am Ausgang 47 des NAND-Gatters 45 entspricht im übrigen dem Signal am Ausgang 35 des Lichtdetektors 26 der Fig. 1.

Das digitale Bandpassfilter 42 kann beispielsweise aus der Parallelschaltung von zwei retriggerbaren Monoflops (d. h. Monoflops, die durch jedes Eingangssignal neu getriggert werden, auch wenn die Eigenzeit des Monoflops noch nicht abgelaufen ist) bestehen, wobei die Ausgänge der beiden Monoflops mit je einem Eingang einer UND-Schaltung verbunden sind. Hierbei weisen die Monoflops Eigenzeiten gemäss den Periodenlängen des Eingangssignals an der unteren bzw. der oberen Grenze des vorgesehenen Durchlassbereichs des Bandpassfilters auf, derart, dass an der unteren Bandgrenze das eine Monoflop gerade noch nicht abläuft, d. h. gerade noch nicht in den Ruhezustand zurückfällt, und an der oberen Bandgrenze das andere Monoflop fortlaufend neu gesetzt wird. Der Durchlassbereich des digitalen Bandpassfilters 42 kann sich beispielsweise und mit Vorteil von 0,5 Hz bis zu 3 Hz erstrecken, um einerseits thermische und andererseits mechanische und akustische Störgrössen zu eliminieren.

Durch das Exklusiv-ODER-Gatter 43 wird jedesmal festgestellt und ein entsprechender Ausgangsimpuls abgegeben, dass bzw. wenn in einem bestimmten Zeitpunkt und innerhalb der durch die Schwellwertdetektoren 41 und Bandpassfilter 42 bestimmten Grenzen am einen photoelektrischen Lichtfühler 27 eine Lichtintensitätsänderung durch Lageveränderung des betreffenden Lichtflecks erfolgt, am andern Lichtfühler 27 jedoch nicht. Das Integrationsglied 44 hat die gleiche Aufgabe wie das Integrationsglied 33 der Fig. 1.

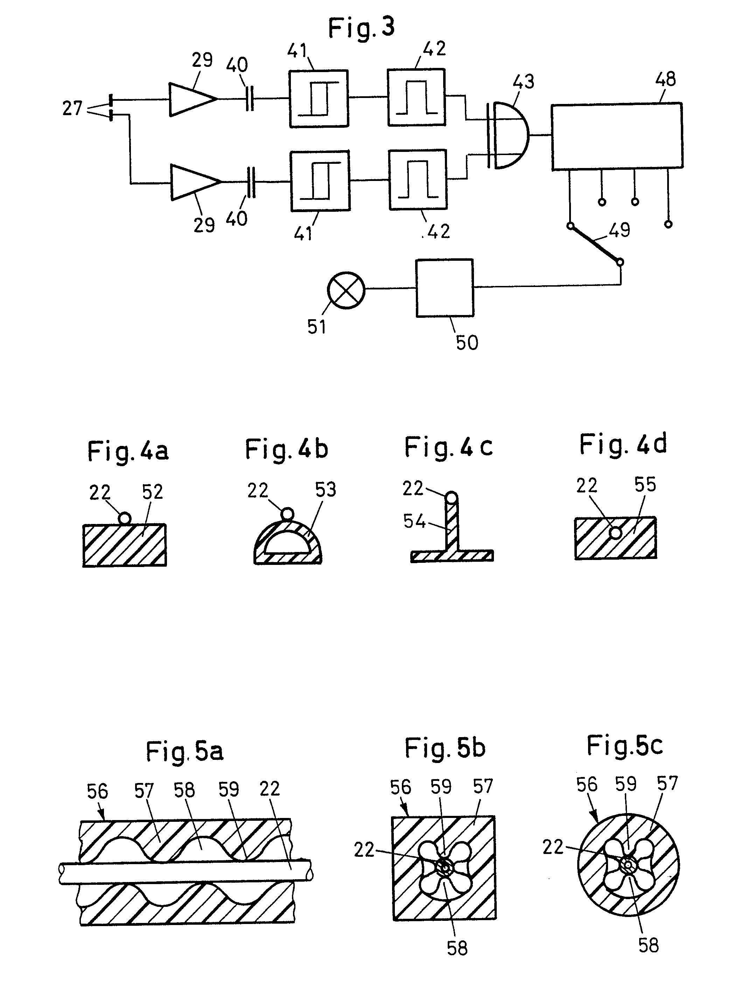

Eine weitere Ausführungsform eines digital arbeitenden Lichtdetektors ist in Fig. 3 schematisch dargestellt. Darin sind die optischen und mechanischen Teile der Schalteinrichtung, welche denjenigen der Fig. 2 entsprechen, weggelassen. In Uebereinstimmung mit dem Lichtdetektor 39 der Fig. 2 ist an jeden der beiden photoelektrischen Lichtfühler 27 wiederum ein Verstärker 29 angeschlossen, dessen Ausgang über einen Kondensator 40 an der Reihenschaltung eines Schwellwertdetektors 41 und eines digitalen Bandpassfilters 42 liegt. Die Ausgänge der Bandpassfilter 42 sind ebenfalls mit Eingängen eines Exklusiv-ODER-Gatters oder Binär-Komparators 43 verbunden.

Der Ausgang des Exklusiv-ODER-Gatters oder Binär-Komparators 43, an welchem Ungleichheitsimpulse der Fehlbitvergleichung erscheinen, ist mit dem Zähleingang eines Dezimal- oder Dualzählers 48 verbunden, der somit die angebotenen Impulse zählt. Die verschiedenen Zählstufen des Zählers 48 sind einzeln mit Anschlüssen eines Wählschalters 49 verbunden, an welchen ein Auslöseglied 50, z. B. ein Speicherelement, angeschlossen ist, das seinerseits einen Schaltvorgang für einen Verbraucher 51, z. B. eine Glühlampe, auslöst.

Der Wählschalter 39 dient zur Einstellung der digitalen Empfindlichkeit des beschriebenen Lichtdetektors, d. h. zur Einstellung der Zahl von Impulsen des Exklusiv-ODER-Gatters 43 (d. h. der Fehlbitrate) bis zur Auslösung des Auslöseglieds 50. Der Zähler 48 entspricht somit dem Integrationsglied 44 der Fig. 2 mit der zusätzlichen Einstellmöglichkeit.

Ausführungsbeispiele für die elastische Unterlage 25 (Fig. 1 und 2) sind in den Fig. 4a bis 4d dargestellt. Gemäss Fig. 4a ist ein Abschnitt der Lichtleitfaser 22 auf einem Kunststoffschaumstück 52 befestigt, z. B. aufgeklebt. Es können auch Kunststoffschaum-Profilstücke verwendet werden, z. B. ein Halbrund-Hohlprofil 53 gemäss Fig. 4b oder ein T-Profil 54 gemäss Fig. 4c oder ein die Lichtleitfaser 22 umgebendes Kunststoffschaum-Stück 55 gemäss Fig. 4d. Alle diese Unterlagen lassen sich ohne Schwierigkeit unter eine bereits bestehende, d. h. verlegte Lichtleitfaser legen, ohne dass die Lichtleitfaser bearbeitet oder aufgetrennt werden müsste.

Eine weitere Ausführungsform der elastischen Unterlagen für die Lichtleitfaser kann darin bestehen, dass die Lichtleitfaser über ihre ganze zu verlegende Länge von einem Kunststoffmantel umgeben ist, in welchem die Lichtleitfaser derart eingebettet ist, dass sie an beliebiger Stelle und in beliebiger Richtung durch Fingerdruck seitlich um eine geringe Strecke verschiebbar ist. In Fig. 5a ist ein Abschnitt eines solchen Lichtleit-Schalterkabels 56 in einem Längsschnitt dargestellt, während die Fig. 5b und 5c Querschnitte dieses Kabels für eine Vierkantausführung bzw. eine Rundausführung zeigen. Aus diesen Figuren ist ersichtlich, dass die Lichtleitfaser 22 in einem Kunststoffmantel 57 derart eingebettet ist, dass zwischen der Aussenfläche der Lichtleitfaser 22 und dem benachbarten Kunststoffmantel 57 mindestens ein sich längs der Lichtleitfaser 22 schraubenlinienförmig erstreckender Hohlraum 58 liegt. Anders ausgedrückt liegt die Lichtleitfaser 22 über mindestens eine sich längs der Lichtleitfaser 22 schraubenlinienförmig erstreckende Rippe 59 des Kunststoffmantels 57 an diesem an. Der Kunststoffmantel 57 kann hierbei als Vierkantprofil (Fig. 5b) oder als Rundprofil (Fig. 5c) ausgebildet sein. Ein solches Lichtleit-Schalterkabel oder Opto-Schalterkabel 56 lässt sich beliebig verlegen und stellt zusammen mit einer Laser-Lichtquelle und einem Lichtdetektor gemäss Fig. 1, 2 oder 3 eine Schalteinrichtung dar, die durch einfachen Fingerdruck o. dgl. zufolge des sich über die ganze Länge der Lichtleitfaser 22 erstreckenden Kunststoffmantels 57 und dessen Rundum-Symmetrie bezüglich der Lichtleitfaser an beliebigen Stellen auslösbar ist.

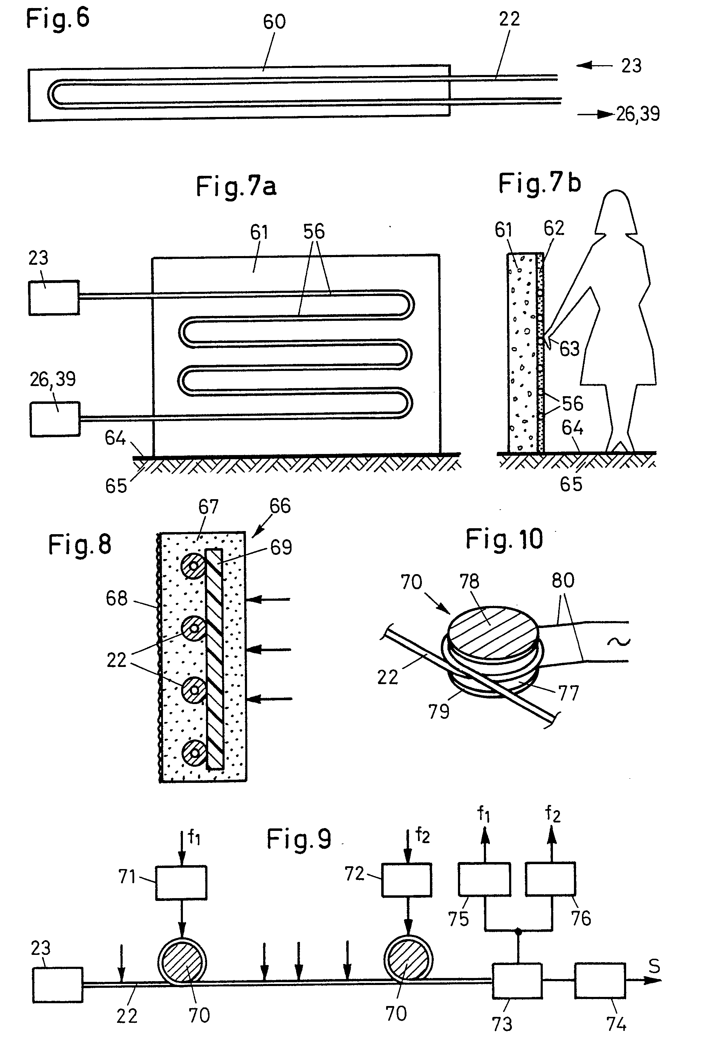

Eine weitere vorteilhafte Ausführungsform eines Lichtleit-Schalterkabels besteht nach Fig. 6 darin, die Lichtleitfaser 22 hin- und hergehend in einem elastisch nachgiebigen Kunststoffmantel anzuordnen, um ein Rundkabel oder vorzugsweise ein Flachkabel 60 (Flachband) zu erhalten. Die Breite eines solchen Flachkabels 60 kann etwa 5 bis 10 mm betragen, seine Länge kann bis zu 1 km sein, so dass sich ein derartiges Schalterkabel insbesondere zur dichten Verlegung auf der Wand eines langen Korridors oder Tunnels eignet. Durch leichten Fingerdruck auf das Kabel an einer beliebigen Stelle kann dann der gewünschte Schaltvorgang ausgelöst werden. Von besonderem Vorteil beim Schalterkabel 60 ist der Umstand, dass am gleichen Kabelende die Einspeisung kohärenten Lichts in das eine Ende der Lichtleitfaser 22 durch einen Laser 23 und die Detektion des aus dem andern Ende der Lichtleitfaser 22 austretenden Lichts durch einen Lichtdetektor 26, 39 gemäss Fig. 1, 2 oder 3 erfolgen kann. Durch die Parallelführung der Lichtleitfaser 22 im Kabel 60 ist zudem eine Veränderung des Lichtfleckmusters am Lichtleitfaserende auch bei sehr kleinem Fingerdruck sichergestellt.

In Fig. 7a ist in Ansicht und in Fig. 7b im Schnitt eine Schalteinrichtung mit einem an einer Wand 61 in einer Verputzschicht 62 mäanderförmig verlegten Lichtleitschalterkabel 56 gemäss Fig. 5 schematisch dargestellt, wobei an das eine Ende der Lichtleitfaser des Kabels 56 gemäss Fig. 1, 2 oder 3 eine Laser-Lichtquelle 23 und an das andere Ende ein Lichtdetektor 26 bzw. 39 angeschlossen sind. Bei einer solchen grossflächigen Wand-Schalteinrichtung erfolgt die Auslösung durch Berühren des Kabels 56 über der Verputzschicht 62 mit der Hand 63, wodurch eine geringfügige seitliche Verschiebung der Lichtleitfaser im Kunststoffmantel des Kabels 56 bewirkt wird und der Lichtdetektor 26 bzw. 39 ein entsprechendes Schaltsignal abgibt.

Analog kann das Lichtleit-Schalterkabel 56 in nicht dargestellter Weise grossflächig in einem flexiblen Belag 64 eines Bodens 65 verlegt sein. Die Auslösung erfolgt dann durch Betreten dieser grossflächigen Boden-Schalteinrichtung.

Eine flächenhafte Schalteinrichtung, beispielsweise zur nachträglichen Anbringung an einer Wand, kann dadurch erhalten werden, dass die Lichtleitfaser in einen elastischen, flachbandförmigen Kabelmantel (entsprechend Fig. 6) mehrfach hin- und hergehend (entsprechend Fig. 7a) eingebettet wird. In Fig. 8 ist ein solches Flachkabel 66 im Schnitt dargestellt. Die mäanderförmig hin- und hergehende Lichtleitfaser 22 ist in einen bandförmigen elastischen Kunststoffmantel 67 eingebettet, dessen Breite etwa 100 bis 200 mm und dessen Dicke 2 bis 3 mm sind, wobei die Länge des Kunststoffmantels 67 beliebig ist und die Enden der Lichtleitfaser 22 am gleichen Ende des Kunststoffmantels 67 aus diesem austreten. Die eine Fläche des Kunststoffmantels 67 ist mit einer selbstklebenden Haftschicht 68 versehen, um das gebildete Flachkabel in einfacher Weise auf einer Wand befestigen zu können. Damit zur Auslösung eines Schaltvorganges auf das Flachkabel an einer beliebigen Stelle in seiner Breitenrichtung gemäss den dargestellten Pfeilen ein leichter Druck ausgeübt werden kann, ohne dass die einzelnen Stränge der Lichtleitfaser 22 sehr nahe beieinander liegen müssen, ist im Kunststoffmantel 67 eine dünne, die Lichtleitfaser 22 überdeckende Druckplatte 69, z. B. aus einem Kunststoff, eingebettet.

Die vorliegende Schalteinrichtung kann auch zur Uebertragung zusätzlicher Informationen über die beschriebene Lichtleitfaser von beliebigen Stellen längs der Lichtleitfaser ausgebildet sein, wobei eine aufwendige Auftrennung der Lichtleitfaser an diesen Stellen nicht erforderlich ist. In Fig. 9 ist eine Schalteinrichtung schematisch dargestellt, die wiederum die Lichtleitfaser 22 und den Laser 23 am einen Ende der Lichtleitfaser 22 enthält, wobei eine Umhüllung der Lichtleitfaser 22 nicht dargestellt ist. An einer oder mehreren Stellen der Lichtleitfaser 22 umschlingt diese ein Wandlerelement 70, das dazu ausgebildet ist, durch angelegte elektrische Wechselspannungen zu entsprechenden Radialschwingungen angeregt zu werden. Vorzugsweise sind die Wandlerelemente 70 piezoelektrische Planarschwinger, welchen Erregungsspannungen nach dem Multiplex-Verfahren über je einen Modulator/Oszillator 71 bzw. 72 zugeführt sind. Beispielsweise moduliert mittels Frequenzmodulation eine Sprachwechselspannung $f_1$ im Modulator/Oszillator 71 eine Hochfrequenzspannung, deren Frequenz im Bereich von 30 kHz liegt, und mittels Pulscodemodulation eine Dateninformation $f_2$ im Modulator/Oszillator 72 eine weitere Hochfrequenzspannung, deren Frequenz im Bereich von 40 kHz liegt. Durch diese Erregungs-Hochfrequenzspannungen werden die Wandler 70 zu Radialschwingungen entsprechender Frequenzen angeregt, welche in transversaler Richtung auf die Lichtleitfaser 22 einwirken. Dadurch ändert sich das Lichtfleckmuster am anderen Ende der Lichtleitfaser 22 nicht nur in Abhängigkeit von z. B. manuell auf die Lichtleitfaser 22 an irgend einer Stelle entsprechend den dargestellten Pfeilen ausgeübten Druckeinwirkungen, sondern auch in Abhängigkeit von den erwähnten Einwirkungen der Wandler 70.

Somit enthält ein dem Ende der Lichtleitfaser 22 zugeordneter Lichtdetektor 73 nicht nur, entsprechend beispielsweise der Fig. 1, mehrere photoelektrische Lichtfühler 27, Verstärker 29, einen Summenverstärker 32 und ein Integrationsglied 33, sondern auch Frequenz- oder Pulsdemodulatoren. Die Bandpassfilter entsprechend den Bandpassfiltern 30 in Fig. 1 werden bei diesem Ausführungsbeispiel dem genannten Integrator nachgeschaltet und umfassen ein erstes Bandpassfilter 74 mit einem Durchlassbereich von beispielsweise 0,5 Hz bis 3 Hz zur Ausfilterung der Signalanteile, welche von den manuellen Druckeinwirkungen auf die Lichtleitfaser 22 herrühren und dazu bestimmt sind, einen Schalter S zu betätigen. Zwei weitere an den Lichtdetektor 73 angeschlossene Bandpassfilter 75 und 76 filtern die Informationssignale $f_1$ und $f_2$ aus.

In Fig. 10 ist ein beispielsweiser Wandler 70 näher dargestellt. Ein Piezo-Planarschwingkörper 77, welchen die Lichtleitfaser 22 einmal umschlingt, ist mit Elektroden 78 und 79 versehen, welchen über Anschlussleitungen 80 die erwähnte modulierte Hochfrequenzspannung zugeführt ist. Die Umschlingung kann auch mehrfach sein, um eine höhere Empfindlichkeit zu erzielen.

**Patentansprüche**

1. Schalteinrichtung mit einer Multimode-Lichtleitfaser, an deren einem Ende eine Quelle mindestens angenähert kohärenten Lichts und an deren anderem Ende ein mindestens einen photoelektrischen Lichtfühler enthaltender Lichtdetektor zur Feststellung und Unterscheidung von durch Einwirkungen auf die Lichtleitfaser hervorgerufenen Aenderungen der optischen Phaseneigenschaften des sich in der Lichtleitfaser fortpflanzenden und am zweitgenannten Ende austretenden Lichts angeordnet sind, wobei mindestens ein Lichtleitfaserabschnitt mit einer elastischen Betätigungsvorrichtung zur Bewirkung einer gezielten und beschränkten transversalen Verschiebung der Lichtleitfaser versehen ist, derart, dass die am zweitgenannten Ende auftretenden Lichtflecken aufgrund der durch die Betätigungsvorrichtung bewirkte transversale Verschiebung der Lichtleitfaser eine Lageänderung erfahren, und wobei der Lichtdetektor ein an den photoelektrischen Lichtfühler angeschlossenes Bandfilter enthält, dadurch gekennzeichnet, dass jeder photoelektrische Lichtfühler (27) des Lichtdetektors (26 ; 39) einem bestimmten Lichtfleck zugeordnet ist und einen Raumwinkel erfasst, der höchstens gleich der Abmessung des zugeordneten Lichtflecks ist.

2. Schalteinrichtung nach Anspruch 1, dadurch gekennzeichnet, dass zwischen dem zweitgenannten Ende (24) der Lichtleitfaser (22) und dem Lichtfühler bzw. allen Lichtfühlern (27) ein Polarisator (28) angeordnet ist.

3. Schalteinrichtung nach Anspruch 1 oder 2, dadurch gekennzeichnet, dass jede Betätigungsvorrichtung (25) eine nachgiebige Unterlage (52 ; 53 ; 54 ; 55 ; 57 ; 67) aufweist, auf welcher der Abschnitt der Lichtleitfaser (22) angeordnet ist.

4. Schalteinrichtung nach einem der Ansprüche 1 bis 3, dadurch gekennzeichnet, dass sich die Betätigungsvorrichtung über mindestens angenähert die ganze Länge der Lichtleitfaser (22) erstreckt und als nachgiebige Ummantelung (57) der Lichtleitfaser ausgebildet ist, um mit der Lichtleitfaser ein Kabel (56) zu bilden.

5. Schalteinrichtung nach Anspruch 4, dadurch gekennzeichnet, dass die Ummantelung (57) über innere Vorsprünge (59), z. B. Rippen, an der Lichtleitfaser (22) anliegt, um mit dieser Hohlräume (58) zu bilden.

6. Schalteinrichtung nach einem der Ansprüche 1 bis 3, dadurch gekennzeichnet, dass die Lichtleitfaser (22) mäanderförmig verlaufend in einen bandförmigen elastischen Kunststoff (67) eingebettet ist, um ein Flachbandkabel (66) zu bilden.

7. Schalteinrichtung nach Anspruch 6, dadurch gekennzeichnet, dass in den elastischen Kunststoff (67) eine auf allen Mäanderwindungen der Lichtleitfaser (22) liegende Druckplatte (69) eingebettet ist.

8. Schalteinrichtung nach einem der Ansprüche 1 bis 7, dadurch gekennzeichnet, dass die jedem Lichtfühler (27) nachgeschalteten Bandpassfilter (30 ; 42) über ein Integrationsglied (33 ; 44) mit einem gemeinsamen Eingang einer Auslöseschaltung (34, 45) in Verbindung stehen, deren Ansprechschwelle durch ein der Summe der von den Lichtfühlern (27) gemessenen mittleren Lichtintensitäten oder der Gesamtintensität des Lichts am zweitgenannten Ende (24) der Lichtleitfaser (22) entsprechendes Signal einstellbar ist.

9. Schalteinrichtung nach einem der Ansprüche 1 bis 8, dadurch gekennzeichnet, dass zur digitalen Auswertung der von Lichtfühlern (27) erzeugten elektrischen Signale an jeden Lichtfühler (27) über einen Schwellenwertdetektor (41) ein digitales Bandfilter (42) angeschlossen ist, und dass die Ausgänge der digitalen Bandfilter (42) über einen Binärkomparator (43) mit einer Integrationsschaltung (44 ; 48) verbunden sind.

10. Schalteinrichtung nach Anspruch 9, dadurch gekennzeichnet, dass die Integrationsschaltung ein Impulszähler (48) ist, dessen Zählstufen über einen Wählschalter (49) mit einem Auslöseglied (50) verbindbar sind, um die Ansprechempfindlichkeit einstellen zu können.

11. Schalteinrichtung nach Anspruch 9 oder 10, dadurch gekennzeichnet, dass das Bandpassfilter (42) einen Durchlassbereich von etwa 0,5 Hz bis 3 Hz hat.

**Claims**

1. A switching device with a multi-mode optical fibre, at one end of which there is arranged a source of at least approximately coherent light and at the other end of which there is arranged a light detector containing at least one photo-electric light sensor for detecting and differentiating between alterations caused by influences on the optical fibre in the optical phase characteristics of the light propagated in the optical fibre and emerging at the above-mentioned other end, at least one optical fibre section being provided with a resilient actuating device to effect a specific, limited transverse displacement of the optical fibre, in such a way that the light spots emerging at the above-mentioned other end undergo a position change owing to the transverse displacement of the optical fibre effected by the actuating device, and the light detector comprising a bandpass filter connected to the photo-electric light sensor, characterized in that each photo-electric light sensor (27) of the light detector (26 ; 39) is associated with a specific light spot and covers a solid angle, which is at most equal to the size of the associated light spot.

2. A switching device according to claim 1, characterized in that between the above-mentioned other end (24) of the optical fibre (22) and the light sensor or all the light sensors (27) there is arranged a polarizer (28).

3. A switching device according to claim 1 or claim 2, characterized in that each actuating device (25) comprises a pliable substrate (52 ; 53 ; 54 ; 55 ; 56 ; 57 ; 67), on which is arranged the section of the optical fibre (22).

4. A switching device according to any one of claims 1 to 3, characterized in that the actuating device extends over at least approximately the whole length of the optical fibre (22) and is constructed as a pliable jacket (57) for the optical fibre, in order to form a cable (56) with the optical fibre.

5. A switching device according to claim 4, characterized in that the jacket (57) abuts the optical fibre (22) by way of inner projections (59), e. g. ribs, in order to form cavities (58) therewith.

6. A switching device according to any one of claims 1 to 3, characterized in that the optical fibre (22) is embedded in meandering manner in a band-form resilient plastics material (67), in order to form a flat-band cable (66).

7. A switching device according to claim 6, characterized in that a pressure plate (69) lying on all the meander turns of the optical fibre (22) is embedded in the resilient plastics material (67).

8. A switching device according to any one of claims 1 to 7, characterized in that the band pass filters (30 ; 42) connected downstream of each light sensor (27) are connected by means of an integrating element (33 ; 44) with a common input of a trigger circuit (34, 45), the response threshold of which is adjustable by a signal corresponding to the sum of the average light intensities measured by the light sensors (27) or the total intensity of the light at the above-mentioned other end (24) of the optical fibre (22).

9. A switching device according to any one of claims 1 to 8, characterized in that a digital band-pass filter (42) is connected to each light sensor (27) by means of a threshold value detector (41) for digital evaluation of the electric signals generated by light sensors (27), and in that the outputs of the digital band-pass filters (42) are connected with an integrating circuit (44 ; 48) by means of a binary comparator (43).

10. A switching device according to claim 9, characterized in that the integrating circuit is a pulse counter (48), the counting stages of which can be connected with a triggering member (50) via a selector switch (49), in order to be able to adjust response sensitivity.

11. A switching device according to claim 9 or claim 10, characterized in that the band-pass filter (42) has a pass range of approximately 0.5 Hz to 3 Hz.

**Revendications**

1. Montage de commutation avec une fibre optique multimode à l'une des extrémités de laquelle est placée une source de lumière au moins approximativement cohérente, et à l'autre extrémité de laquelle est placé un détecteur optique comprenant au moins un capteur optique photo-électrique, pour détecter et différencier des variations des propriétés de phase optiques, provoquées par des actions sur la fibre optique, de la lumière se propageant dans la fibre optique et sortant à l'extrémité mentionnée en second lieu, au moins une section de la fibre optique comportant un dispositif d'actionnement élastique pour provoquer un déplacement transversal approprié et limité de la fibre optique, de telle façon que les spots apparaissant à la seconde extrémité subissent une variation de position en raison du déplacement transversal de la fibre optique provoqué par le dispositif d'actionnement, et le détecteur optique comprenant un filtre passe-bande raccordé au capteur optique photo-électrique, caractérisé en ce que chaque capteur optique photo-électrique (27) du détecteur optique (26 ; 39) correspond à un spot déterminé et embrasse un angle solide qui est au plus égal à la dimension du spot lumineux correspondant.

2. Montage de commutation selon la revendication 1, caractérisé en ce qu'un polariseur (28) est placé entre l'extrémité (24), mentionnée en second lieu, de la fibre optique (22) et le détecteur optique ou tous les détecteurs optiques (27).

3. Montage de commutation selon la revendication 1 ou 2, caractérisé en ce que chaque dispositif d'actionnement (25) comporte une base élastique (52 ; 53 ; 54 ; 55 ; 57 ; 67) sur laquelle est placée la section de la fibre optique (22).

4. Montage de commutation selon l'une des revendications 1 à 3, caractérisé en ce que le dispositif d'actionnement s'étend, au moins approximativement, sur toute la longueur de la fibre optique (22) et est réalisé sous la forme d'une gaine flexible (57) de la fibre optique pour constituer un câble (56) avec la fibre optique.

5. Montage de commutation selon la revendication 4, caractérisé en ce que la gaine (57) est en contact, par l'intermédiaire de saillies intérieures (59), par exemple des nervures, avec la fibre optique (22), pour former avec elle des cavités (58).

6. Montage de commutation selon l'une des revendications 1 à 3, caractérisé en ce que la fibre optique (22) est incorporée, suivant une allure sinueuse, dans une matière plastique élastique en forme de ruban (67), pour constituer un câble-ruban plat (66).

7. Montage de commutation selon la revendication 6, caractérisé en ce qu'une plaque de compression (69) placée sur toutes les sinuosités de la fibre optique (22) est incorporée dans la matière plastique élastique (66).

8. Montage de commutation selon l'une des revendications 1 à 7, caractérisé en ce que les filtres passe-bande (30 ; 42) intercalés à la suite de chaque capteur optique (27) sont en liaison, par l'intermédiaire d'un organe intégrateur (33 ; 34), avec une entrée commune d'un montage de déclenchement (34, 45) dont le seuil de réaction peut être réglé par un signal correspondant à la somme des intensités lumineuses moyennes mesurées par les capteurs optiques (27) ou à l'intensité totale de la lumière à la seconde extrémité (24) de la fibre optique (22).

9. Montage de commutation selon l'une des revendications 1 à 8, caractérisé en ce que, pour le traitement numérique des signaux électriques engendrés par les capteurs optiques (27), un filtre passe-bande numérique (42) se raccorde à chaque capteur optique (27) par l'intermédiaire d'un détecteur à seuil (41), et en ce que les sorties des filtres passe-bande numériques (42) sont reliées, par l'intermédiaire d'un comparateur binaire (43), à un montage intégrateur (44 ; 48).

10. Montage de commutation selon la revendication 9, caractérisé en ce que le montage intégrateur est un compteur d'impulsions (48) dont les étages de comptage peuvent être reliés, par l'intermédiaire d'un sélecteur (49), à un organe de déclenchement (50) pour permettre de régler la sensibilité de réaction.

11. Dispositif de commutation selon la revendication 9 ou 10, caractérisé en ce que le filtre passe-bande (42) a une bande passante d'environ 0,5 Hz à 3 Hz.

Fig.1

22
23
25
29
30
31
32
33
34
35
28
36
24
27
37
26
29
38

Fig. 2

22
23
25
29
40
41
42
43
44
45
47
28
36
24
27
37
39
29
38
46

0 074 927

# Fig. 3

29  40  41  42  43  48

27

29  40  41  42

49

51  50

# Fig. 4a    Fig. 4b    Fig. 4c    Fig. 4d

22  52      22  53      22  54     22  55

# Fig. 5a

56  57  58  59  22

# Fig. 5b

56  59  57
22
58

# Fig. 5c

56  59  57
22
58

**Fig.6**

**Fig.7a**

**Fig.7b**

**Fig.8**

**Fig.10**

**Fig.9**